Europäisches Patentamt

European Patent Office

Office européen des brevets

(19)

Publication number: **0 299 232**

**A1**

# EUROPEAN PATENT APPLICATION

(21) Application number: 88109825.5

(22) Date of filing: 21.06.88

(51) Int. Cl.4: **G01R 1/073**

The title of the invention has been amended (Guidelines for Examination in the EPO, A-III, 7.3).

(30) Priority: 22.06.87 US 65291

(43) Date of publication of application:
**18.01.89 Bulletin 89/03**

(84) Designated Contracting States:
**AT BE CH DE ES FR GB GR IT LI LU NL SE**

(71) Applicant: **EVERETT/CHARLES CONTACT PRODUCTS INC.**
**700 East-Harrison avenue**
**Pomona California 91767(US)**

(72) Inventor: **St. Onge, Gary F.**
**RD no. 5 Westline Road**
**Amsterdam, NY 12010(US)**

(74) Representative: **Dipl.-Ing. H. Marsch Dipl.-Ing.**
**K. Sparing Dipl.-Phys.Dr. W.H. Röhl**
**Patentanwälte**
**Rethelstrasse 123**
**D-4000 Düsseldorf 1(DE)**

(54) **Circuit board test fixture.**

(57) A test fixture for use in computerized automatic test equipment for checking printed circuit boards (18). A "bed of nails" type of test fixture is used in which probes (37) are used to contact selected test points on the board to be tested. An interface unit (72) electrically connects the probes in the "bed of nails" to a contact panel portion of the fixture (92) which is coupled to the computerized system. Such a connection has been made in the prior art with manually connected insulated wires which resulted in a mass of wires inside the fixture. Instead, the present technique utilizes an interface board of either the printed circuit or printed wire type. A set of alignment plates (61,106) is provided to cooperate with the interface board in aligning and retaining the probes parallel to each other during assembly and thereafter. Fixtures are made faster and more reliably with this technique, and debugging is facilitated by elimination of the mass of wiring which had to be contended with previously.

Fig. 2

## WIRELESS TEST FIXTURE

### Background Of The Invention

The present invention is related to a test fixture for use in computerized automatic test equipment for checking printed circuit boards and, more particularly, to a fixture which does not utilize individual wires manually connected between one set of pins adapted for making contact with the computerized test system and another set of pins adapted to contact the printed circuit board under test.

Automatic test equipment for checking printed circuit boards has long been well known. For the sake of consistency and convenience, the printed circuit board and the circuitry thereon to be checked will be referred to hereafter as a "unit under test", or "UUT". A standard approach utilizes a "bed of nails" test fixture in which a great number of arrayed nail-like test probes is provided having tips arranged to make electrical contact with nodal points of the UUT. Any particular circuit laid out on a printed circuit board is likely to be different from all other circuits. Consequently, a "bed of nails" arrangement for contacting nodes in a particular circuit must be customized to that circuit. When the circuit to be tested is designed, a pattern of nodal points to be used in checking it is selected, and a corresponding array of test probes is configured in a fixture. A typical fixture may have five hundred test probes, and some even go up to two thousand in number.

A test fixture, thus, functions as an interface between the computerized automatic test equipment system ("system" hereafter) which generates test signals to the UUT and receives the resulting signals sensed from the UUT. A UUT access portion of the test fixture is adapted to engage test nodal points selected for checking the UUT whereas a system access portion of the test fixture is adapted to communicate with the system. Electrical connections between the UUT access portion and the system access portion have been made with a wire-wrap approach which is highly manually intensive. Specifically, when a pin from the system access portion is to be placed in electrical communication with a pin from the UUT access portion, a coated, insulated wire is soldered to and run between the two pins. Consequently, each of the hundreds of such interconnections must be made manually, individually, and sequentially in order to manufacture a test fixture. Some semi-automatic means have been developed to help in this process, but it remains labor intensive, nevertheless.

Although the wire-wrap technique is in widespread use, it has many disadvantages. For example, the manual operations required can be performed only relatively slowly because a) two pins out of hundreds, if not thousands, of pins must be identified, and b) the wire must be manually connected (such as by soldering a wire wrapping) to the identified pins. Consequently, production of a fixture requires a considerable amount of time to complete. Since printed circuit boards cannot be shipped by the manufacturer unless they are checked first, delay caused by waiting for the production of a test fixture has a ripple effect in terms of late product shipments. However, no way exists for appreciably and satisfactorily speeding up this manual production process to any considerable extent because typically only one operator can work on a test fixture at a given time so that it is not possible to simply put more people on the job.

Another drawback of this wire-wrap approach is its tendency to generate wiring mistakes. The pins are arrayed in a high density arrangement in order to provide the capability of maximizing the testing functions applied to the UUT in terms of the number of nodes that can be accessed. Consequently, identifying the correct pin in this high density array to which a wire must be soldered is an operation which requires a great deal of care and is subject to a relatively high degree of error. If speed is increased, the care and attention which can be devoted to it are diminished, thereby resulting in more errors. Furthermore, once the fact that a wiring error has occurred is established, debugging the board to correct the error is very difficult. A mass of hundreds of wires must be pushed aside to allow test instruments to contact the various pins to determine which have been mis-wired. Access for such test instruments is hampered, and so is the view of the operator. Moreover, when the mis-wired pin is found, the wire must first be disconnected and then the wire moved to the correct pin. Again, access for the necessary tools is hindered by the wire mass. It can readily be seen that the wire wrap approach is difficult to work with in manufacturing the test fixture as well as servicing it. It is prone to error, slow, and expensive. Consequently, another approach without these drawbacks is highly desirable.

### Summary Of The Invention

It is a primary object of the present invention to provide a test fixture for use in a computerized automatic test equipment system which avoids the need for manually running and soldering individual wires between the UUT access portion and the system access portion of the fixture.

It is another object of the prsent invention to provide a technique for producing a test fixture which facilitates obtaining correctly wired connections between the UUT access portion and the system access portion of the fixture.

Another object of the present invention is to provide a test fixture which can be manufactured relatively quickly.

A further object of the invention is to provide a test fixture which can be manufactured at relatively low cost.

Yet another object of the present invention is to provide a test fixture which is relatively easy to service.

Still another object of the present invention is to provide a test fixture that facilitates making changes to the pin interconnections.

These and other objects of the present invention are attained by one aspect of the invention directed to a test fixture for checking a printed circuit board comprising an array of electrically conductive pins facing in a common direction with a tail at one end and a contact head at another end. A mounting means securely retains this array of electrically conductive pins in alignment with test points on a printed circuit board test unit. A means is provided for bringing this array of electrically conductive pins and the test points on the test unit into engagement with each other, respectively. A contact panel mounts an array of probes adapted to engage a corresponding array of contacts connected to a computerized source of test signals designed for checking the test unit. An interface is coupled between the probes of the contact panel and the array of electrically conductive pins. Such interface comprises: an interface board having an access portion and a contact panel portion, the access portion including an array of connectors secured to the interface board and aligned, respectively, in positions corresponding to, and being in electrical contact with, the array of electrically conductive pins; the contact panel portion having an array of connectors secured to the interface board and aligned, respectively, in positions corresponding to, and being in electrical contact with, the contact panel probes; and a pattern of conductive lines on the interface board connecting respective ones of the array of connectors on the access portion with respective ones of the array of connectors on the contact panel portion.

Another aspect of the invention is directed to a method for manufacturing a test fixture for use in computerized testing of printed circuit boards, comprising the steps of: mounting an array of electrically conductive pins in positions corresponding with test points on a printed circuit board test unit; aligning the array of pins by placing a first alignment plate so the pins are snugly received within holes in the plate, the holes in the alignment plate being located in positions corresponding with test points on a printed circuit board test unit: electrically coupling the pins, respectively, to discrete points on an interface board; providing an interface board and forming a pattern of conductive lines thereon connecting, respectively, the discrete points and an array of points on a contact panel portion of the interface board adapted to receive computerized test signals for testing the printed circuit board test unit.

A further aspect of the present invention is directed to an interface board for use in a test fixture which is part of a computerized system for checking printed boards, the interface board comprising: an access portion and a contact panel portion; the access portion including an array of discrete electrical contact points corresponding in position to selected test points on a printed circuit board test unit; the contact panel portion including an array of discrete electrical contact points corresponding in position to pins mounted in the computerized test system and adapted to be coupled to a source of test signals; and a pattern of conductive lines electrically connecting the respective contact points in the access portion and contact panel portion of the interface board.

## Brief Description Of The Drawings

Fig. 1 is a perspective view of an exemplary test fixture mounted in an assembly for placing it in communication with the system.

Fig. 1A is a perspective view of a prior art test fixture of the type shown in Fig. 1, but with its top open to expose the mass of wiring inside it.

Fig. 2 is a side elevational view in cross section of a test fixture configured in accordance with the present invention.

Fig. 3 is an expanded view of drawing portion III circled by a broken line in Fig. 2.

Fig. 4 is a plan view of an interface board in accordance with the present invention for connecting pins in the panel access portion to pins in the UUT access portion of the test fixture.

## Detailed Description Of The Preferred Embodiment

In the following discussion, details of the test fixture of the present invention are described in connection with a particular type of fixture sold by Factron of Latham, New York under the Thinline brand. It shows a panel access portion offset from the UUT access portion. Although the disclosure pertains specifically to that type of test fixture, it should be understood that the present invention applies to other types of test fixtures as well, such as those having a panel access portion aligned with a UUT access portion. The key common element of all test fixtures for which the present invention is applicable and particularly advantageous is their reliance on the wire wrap approach described above.

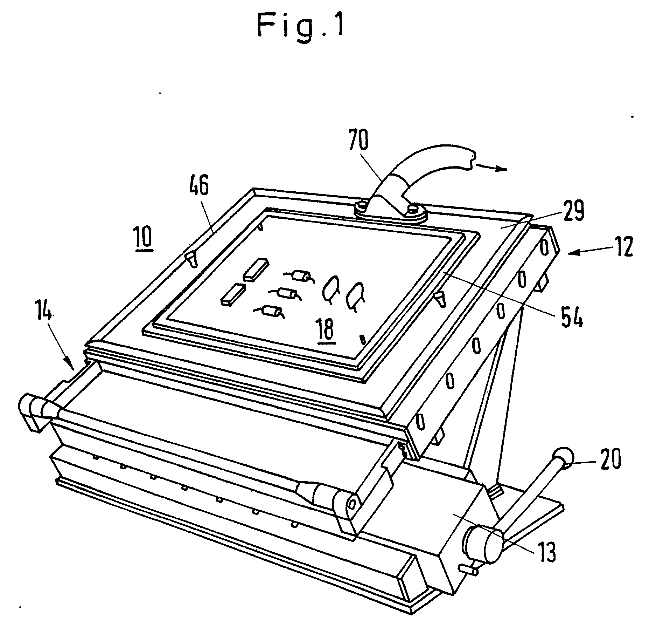

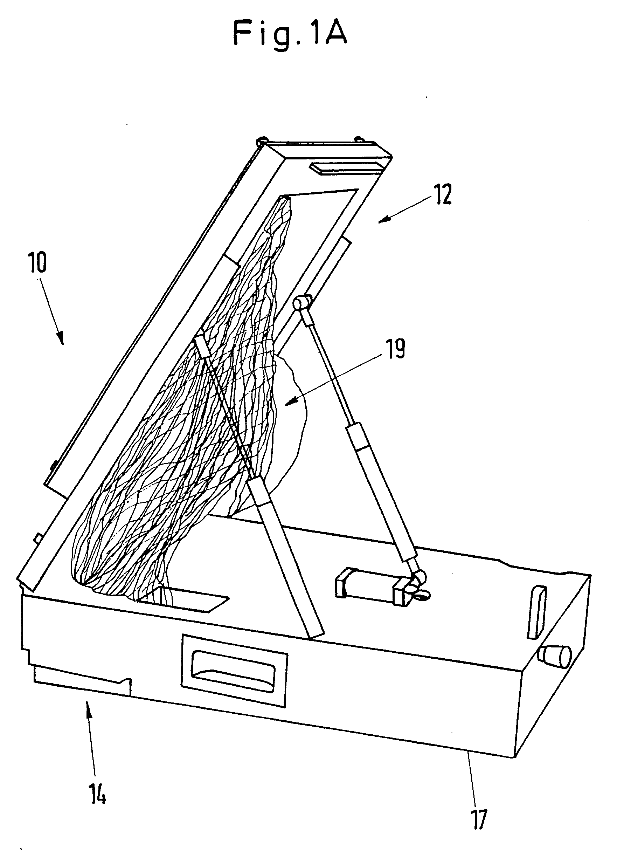

Fig. 1 shows a test fixture generally identified as 10. UUT access portion 12 carries a UUT 18 having various electronic devices mounted thereon. A movable plate 29 is provided along its entire outer periphery with gasket 46. UUT 18 is above movable plate 29 and separated therefrom by a sealing gasket 54 on which UUT 18 rests. Gaskets 46 and 54 assist in forming and maintaining a vacuum under the UUT, as described below. Hose 70 is connected to a vacuum source (not shown). When the vacuum is activated, it produces forces as a result of which board 18 is lowered onto a bed of nails, as better shown and described below with reference to the ensuing drawings. System access portion 14 rests on a receiver 13. Receiver 13 includes pins to which the system (not shown) is connected. A lever arm 20 is utilized to bring corresponding pins in the contact panel 14 and in receiver 13 into engagement. Other details of contact panel 14. receiver 13, and associated components can be found in U.S. Patent No. 4,352,061 issued to John L. Matrone on September 28, 1982, and in the brochure "Thin line Vacuum Fixture Systems and Contact Test Probes" identified as DJM 3422 5M 1286, both of which are hereby incorporated by reference.

As explained above, the main drawbacks of this type of prior art test fixture have to do with the extensive wiring it has which must be manualy installed. Fig. 1A vividly shows the mass of wiring which results. The fixture shown is of the type having a top which can be swung to an open position. The top includes the movable plate and vacuum well parts (not clearly seen in this view), and associated components, as previously described. The top is, therefore. the UUT access portion 12 of the test fixture. The contact panel portion 14 is attached to frame 17. A dense mass of wiring 19 is clearly visible between probes in the UUT access portion and the contact panel portion of test fixture 10. It is this mass of wiring the elimination of which is sought.

The details described up to this point are merely exemplary and form no part of the present invention. It must be stressed that they are presented only for providing one test fixture environment. out of others which are·known and available. for explaining the present invention succinctly and with clarity. The details disclosed in U.S. Patent No. 4.352.061 are illustrative of a test fixture having a panel access portion and a UUT access portion. and such details should not in any way be considered in the context of limiting the present invention.

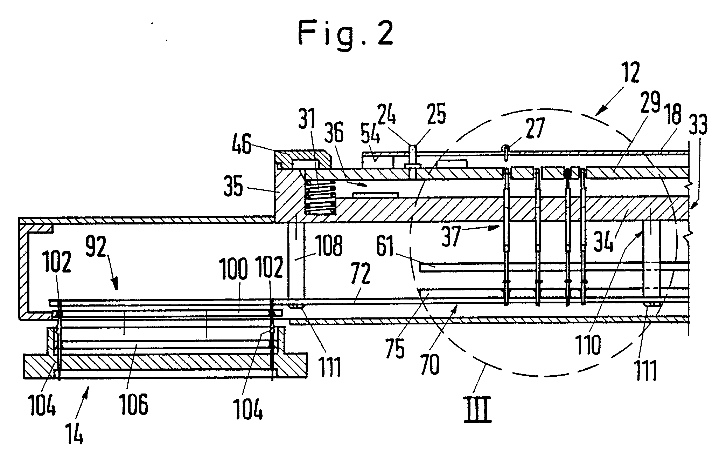

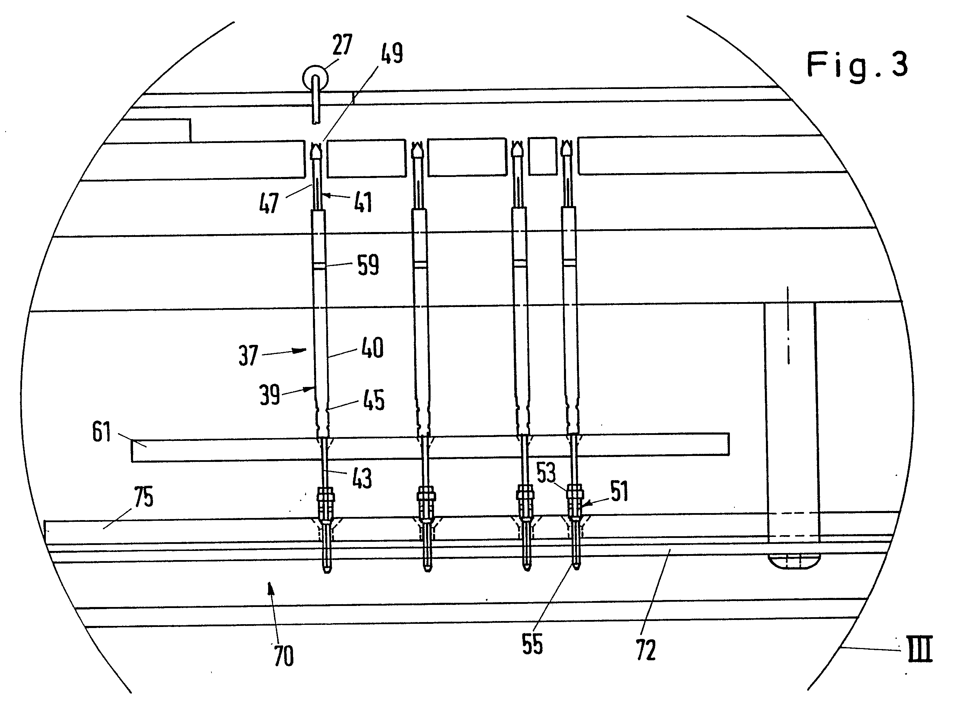

Fig. 2 is a cross-sectional side view of a test fixture constructed in accordance with the principles of the present invention. The UUT 18 rests on gasket 54 and is accurately positioned on the text fixture by guide pins 24 (only one is shown) accommodated within openings 25 in board 18. A circuit component 27 is shown in its mounted position on board 18. Gasket 54 and guide pins 24 are secured to a moving top plate 29 resiliently mounted by spring 31 to vacuum well 33. Vacuum well 33 is constructed of a solid piece having a bottom 34 (except for drilled holes therein discussed below) and side walls 35 to form a cavity 36 into which movable plate 29 can be drawn. Gasket 46 is attached (as by an adhesive, for example) to wall 35 of vacuum well 33 as well as to moving plate 29 in an airtight manner so as to maintain a vacuum within cavity 36 when the vacuum source is activated. Thus, when air is evacuated by the vacuum source from cavity 36, a sealing action is performed by gaskets 46 and 54. The force created by that vacuum is communicated to the UUT via the holes in moving plate 29 which are wider than contact tips 49 (see Fig. 3). As a result. UUT 18 is pressed down onto gasket 54. Also movable plate 29 is forced to descend against the opposed resilient force applied by spring 31 as it is compressed. As movable plate 29 descends, gasket 46 expands in width enough to travel along with movable plate 29 so that the vacuum in cavity 36 is not impaired.

A pattern of holes is drilled into movable plate 29 which corresponds to the particular test configuration of the selected nodes in the UUT. When a circuit is designed. certain, if not all, of its nodes may need to be accessed for applying test signals to the UUT and, in turn, sensing measurement signals from the UUT. The pattern of holes drilled into movable plate 29 can be made to correspond to all potential test nodes with the selection of particular ones being reserved for later, or to correspond with only those nodes actually selected for the test. Bottom 34 of movable plate 33 is also drilled with the same pattern of holes provided in movable plate 29. A continuous coating (not shown. but conventional and well known) is applied to the underside of bottom 34 after it is drilled. The is perforated by probes 37 as they are installed. This coating seals around probes 37 to maintain a vacuum in cavity 36.

When the test program for checking the UUT is developed. at least some of those holes will be provided with probes (or pins) adapted to come in contact with the selected UTT test nodes. The probes are identified generally by numeral 37. and are more clearly shown in Fig. 3 which is an expanded version of the circled portion of Fig. 2 identified by III. Each probe includes a wire wrap receptacle 39 and a probe element 41. Receptacle 39 includes a cylindrical housing 40 into which tail 43 is inserted and crimped, as at 45. Probe element 41 has only its top portion showing with the rest of it being accommodated inside housing 40. It includes shaft 47 with a contact tip 49 at one end and its other end slidably accommodated within a probe housing (not shown) which is secured within receptacle 39. Shaft 47 is spring loaded within the probe housing so that it is urged to remain in its position as depicted in Fig. 3. Probe 37 is a conventional component in common use. It is available from Factron and is described in detail in the brochure "Thin line Vacuum Fixture Systems and Contact Test Probes" identified as DJM 3422 5M 1286. All of the components of probe 37 are configured so that electrical communication is always maintained between contact tip 49 and tail 43.

Referring to Figs. 2 and 3, as movable plate 29 descends under the force applied to it by the vacuum, contact tips 49 begin to protrude above movable plate 29. As it continues to descent, movable plate 29 carries board 18 down with it until contact is made between tips 49 and the corresponding nodes selected for test such as, for example, that involving component 27.

As shown in Figs. 2 and 3, wire wrap receptacles 39 are tightly inserted into the holes formed in bottom 34 of vacuum well 33. An annular ring 59 formed on housing 39 is compressed into the holes in vacuum well 33 to securely seat receptacle 39 in place. This mounting arrangement is effective for securely retaining probes 37 in vacuum well 33. However, some play exists which allows lateral movement of tails 43. In order to more firmly anchor probes 37 in position so they remain parallel relative to one another, an alignment plate 61 is provided which is part of an interface 70, discussed below. Plate 61 also includes a pattern of holes drilled therein to match the pattern of potential test nodes in the UUT. The diameter of the holes formed in alignment plate 61 is such that it fits snugly around tails 43 of receptacle 39. However, each of these holes is widened (as shown in broken lines), such as by a countersinking operation, at the surface which faces the housing of receptacle 39. This facilitates the insertion of tail 43 into these holes. As tails 43 are fully inserted into the holes of alignment plate 61, it comes to rest against the housing of receptacle 39. In this position, the alignment plates are retained parallel to each other by virtue of being fixed at two points, namely in vacuum well 33 and by alignment plate 61. This accurate alignment of probes 37 in parallel relatively to each other is very important for carrying out a further assembly step in the manufacture of the test fixture, as explained below.

Alignment plate 61 may have more holes drilled therein than the number of probes 37 mounted in vacuum well 33. The lack of a one-to-one relationship may interfere with identification of the particular holes into which probes 37 fit and, thereby, hinder assembly of test fixture 10. This hurdle can be overcome by providing guide holes (not shown) in, for example, the four corners of alignment plate 61. Guide pins (not shown) extending from, for example, vacuum well 33 can be provided which fit into the guide holes. Thus alignment plate 61 would be oriented to insert the guide pins into its guide holes. This would automatically also align the pattern of holes therein with the pattern of probes 37.

Push-on connectors 51 are placed onto tails 43 of wire wrap receptacles 39. Each of push-on connectors 51 comprises a receiver end 53 and a shaft 55. Tail 43 is firmly engaged to form an electrical connection within receiver end 53. The push-on connector 51 is a standard item available from Mill-Max Manufacturing Corporation of Oyster Bay, New York under the Wrapost receptacle brand.

A salient feature of the present invention adds a significant contribution to the prior art in eliminating the need for wires as per the wire wrap approach. It involves an interface 70 for placing probe tips 49 and probes in the contact panel (discussed below) in electrical communication. Specifically, interface 70 includes an interface board 72 with holes formed therein to match the pattern drilled in movable plate 29, vacuum well 33, and alignment plate 61. These holes receive therein the shaft 55 of push-on connectors 51. A soldering connection is then made to attach shaft 55 to board 72.

Because board 72 is relatively thin, the structural integrity of connector 51 may not be satisfactory. In other words, connector 51 may wobble or become misaligned to an undesirable extent because that will interfere with assembly of the fixture (as explained below). Consequently, interface 70 is provided with a second alignment plate 75 which is similar to alignment plate 61 in that it has the same pattern of holes drilled therein. These holes are also countersunk at one surface of the alignment plate to facilitate the admission of shafts 55 thereinto. Because the holes drilled in alignment plate 75 snugly accommodate shafts 55 therein, they are narrower than receiver end 53. Consequently, alignment plate 75 rests on a shoulder formed by the receiver end 53. Before shaft 55 is soldered to interface board 72, it is fully inserted so that alignment plate 75 abuts against interface board 72. Interface board 72 and alignment plate 75 are not secured to each other directly. However, alignment plate 75 is maintained in place by being retained between a shoulder on receiver end 53 and interface board 72. With alignment plate 75 augmenting the thickness of interface board 72, push-on connector 51 is not subject to wobble beyond an undesirable point and, consequently, the structural integrity of the overall arrangement in maintaining connectors 51 in proper alignment is enhanced.

Both of alignment plate 75 and interface board 72 can be provided with a guide arrangement to facilitate alignment of the hole pattern therein with probes 37. Such an arrangement can be similar to that described above in detail with respect to alignment plate 61.

So far, an arrangement has been disclosed for completing an electrical connection from a selected test node on UUT 18, via contact point 49 of probe 37, through probe 37 to its tail end 43, and receiver end 53 of push-on connector 51 to its tip 55 which is soldered to interface board 72.

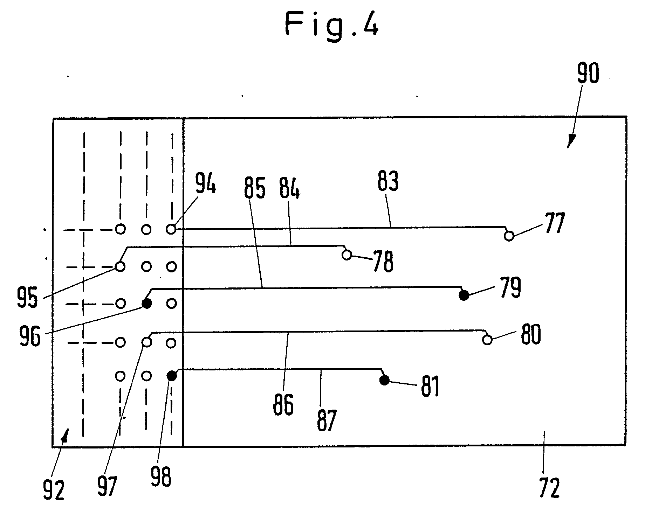

Turning now to Fig. 4, a plan view of interface board 72 is depicted. Interface board 72 has a UUT access portion 90 and a contact panel portion 92. Board access portion 90 is adapted to cooperate with the various components described above that are aligned with the test nodes in the UUT. Contact panel portion 92, on the other hand, is adapted to cooperate with contact panel portion 14 of test fixture 10, in the manner described below. Holes 77-81 are formed in the UUT access portion 90 of board 72. As stated above, these holes are specifically positioned to correspond with potential or actual test nodes of the UUT. However, not all need to be selected for carrying out a particular test in the manner desired. Consequently, for purposes of illustration, only holes 79 and 81 are depicted as being used for conducting the test. Holes 79 and 81 have a soldered connection with shaft 55 of connector 51 which is illustrated by solidly filling these holes on the drawing while leaving the other holes blank. Board 72 can be either a printed circuit board or a printed wire board. As is well known, both of these boards are flat and can accommodate a high density of conductive lines (defined as discrete insulated wires for the printed wire board or masked conductive lines for the printed circuit board. These lines are identified as 83-87.

Contact panel portion 92 includes a regularly spaced array of holes drilled therein. The term "regularly spaced array" is meant to describe a dense arrangement of equally spaced holes which is not necessarily customized to the UUT, unlike the customized holes drilled in UUT access portion 90 of interface board 72. Of course, interface board 72 can be drilled with a pattern in its contact panel portion 92 which is also customized to match that in its UUT access portion. However, it is simpler for mass production manufacturing purposes to pre-manufacture interface board 72 with the holes uniformly drilled in the contact panel portion irrespective of what eventually is done in the UUT access portion 90. In any case, once the array of test nodes has been determined, the UUT access portion 90 of interface board 72 is laid out so that each of holes 77-81 is electrically communicated with one of the holes in contact panel portion 92. The board is then fabricated to form lines 83-87. In the specific version shown in Fig. 4, lines 83-87 provide an electrical connection to, respectively, holes 94-98 in contact panel portion 92. Thus, holes 77-81 in UUT access portion 90 are in electrical communication, respectively, with holes 94-98 in contact panel portion 92.

Returning now to Fig. 2, it depicts contact panel 14 aligned directly underneath contact panel portion 92 of interface board 72. Interface 70 also includes an alignment panel 100 which cooperates with contact panel portion 92 to retain push-on connectors 102 in position. Alignment panel 100 is drilled with the same hole pattern as provided in contact panel portion 92 of board 72. Push-on connectors 102 are the same as connectors 51 used in the UUT access portion 90 of board 72. The post of each connector 102 passes through holes in alignment panel 102 and interface board 72 to which they are soldered. Thus, alignment board 100 is held in place by virtue of its resting on a shoulder of the receiver end of connectors 102 and being pressed into abutment against interface board 72. It is maintained in this position because of the soldered connection between connectors 102 and board 72, just as described above for alignment board 75. With this arrangement, the receiver end of connector 102 faces probes 104 in contact panel 14. Probes 104 are secured to contact panel 14 with the assistance of a further alignment plate 106 drilled with the same hole pattern as is provided in alignment plate 100. When the contact panel 14 is secured in place, probes 104 are accommodated to make electrical contact within the receiver end of connectors 102.

Contact panel 14 is provided with as many probes arrayed to correspond with the number of holes drilled in the contact panel portion 92 of board 72. Thus, each probe 104 in contact panel 14 has a corresponding hole in contact panel portion 92 into which a push-on receiver 102 can be secured. However, contact panel portion 92 is provided with connectors 102 only in those locations needed to accommodate the number of selected test nodes in the circuit to be tested. In the version depicted in Fig. 4, for example, connectors 102 have been soldered only into openings 96 and 98 in contact panel portion 92 of board 72.

Interface board 72 is retained in place within fixture 10 by virtue of threaded bosses 108 and 110 and screws 111 to maintain it accurately in a flat condition so that the electrical contacts within test fixture 10 are made reliably and in the manner planned as vacuum is applied.

It should be readily apparent from the above, that connections have been provided within test fixture 10 to put the system in communication with the probe contact tips 49 without the use of any manually installed wiring extending between the contact panel probes and the wire wrap receptacles. The required electrical connections are made by virtue of interface 70 which has been fabricated in a customized manner relative to the UUT. The lines in interface board 72 for making the electrical connections can readily be laid out by a computer aided design (CAD) system which considerably contributes to the speed and accuracy with which the total manufacturing process of the test fixture is completed. Also, rather than requiring the laborious, multiple number of manual operations needed with the prior art wire wrap approach, the conductive line interconnections are made by a machine which prepares the printed circuit board or the printed wire board, as the case may be. The latter operation is, of course, done by a conventional PWB or PCB apparatus. The CAD layout and the automated, machine-made interconnections minimize the chance of error. Consequently, the result of utilizing the approach of the present invention produces a test fixture faster, better, and cheaper than that which is possible with the prior art wire-wrap approach.

Should a wiring modification be required in the test fixture because, for example, of an engineering design change, an error in the test program, or a wiring error, the present invention easily lends itself to making it. Whereas with the prior art wire-wrap approach the operator had to make his way through a mass of wires to locate the pin or pins of interest and to perform the needed opeations, no such mass of wires to contend with exists. Instead, all the pins are readily accessible either, for example, to apply to test probe or to make the necessary soldering and unsoldering connections. Thus, if it is found that a connection should have been made from hole 96 to hole 78 instead of from hole 96 to hole 79, all that needs to be done is to run a wire manually from probe 94 to tail 43 of the particular probe 37 which is aligned with hole 78. At the same time, push-on connector 51 in hole 79 is removed by desoldering. Although a discrete wire is manually run in order to make this change, as is done with the wire wrap approach, only a single wire is involved and, therefore, the operation is relatively easy, fast and reliable. Several such changes can readily be made without running into the problem of contending with a mass of wires. However, if a significant number of such changes are necessary, then it may be preferable to replace interface board 72.

In fabricating test fixture 10, the following steps are performed. Contact panel 14, movable plate 29, vacuum well 33, and probes 37 are all fabricated and assembled in the conventional fashion. Alignment panels 61 and 75 along with UUT access portion 90 of board 72 are drilled to correspond to the selected pattern of test nodes. Alignment panel 61 and 75 are countersunk. Alignment panel 61 is then slipped over tails 43 of probes 37 (with the assistance of the previously discussed guide holes and guide pins, if used). It is to be noted here that in fabricating the test fixture, it is positioned upside-down to the way it is shown in Fig. 2. In other words, probe tips 49 point downward and tails 43 point upward. Thus, alignment panel 61 is at the top of the test fixture 10 assembled up to this point. Alignment panel 61 is pushed down so that it rests on the shoulder of housing 40 of probes 37. Once alignment panel 61 is in place, push-on connectors 51 are placed atop tails 43 and pushed firmly down until tails 43 are fully engaged therein. Alignment panel 75 is then slipped over shafts 55 of connectors 51 (also with the previously discussed guide holes and guide pins, if used). This operation might be very difficult to perform if it weren't for the accurate alignment of probes 37 achieved by the provision of alignment plate 61. With a dense array of probes 31 and corresponding holes, matching them up for insertion is an all or nothing operation. Even if only one probe is misaligned, it alone prevents the installation of alignment plate 75 and, more importantly, board 72.

After all connectors 51 are slipped into the holes of alignment plate 75, it is pressed down firmly until it rests on the shoulder of receiver end 53 of connectors 51 (also with the previously discussed guide holes and guide pins, if used). At that point, interface board 72 is slipped onto shafts 55 of connectors 51. The positioning of the board can also be facilitated with the use of guide pins (not shown), possible on alignment plate 75, much in the same way as discussed above with respect to installation of alignment plates 61 and 75. Board 72 is pressed down until it abuts onto alignment plate 75. Then, shafts 55 are soldered to board 72. Proceeding now from this portion of board 72 to the contact panel portion 92, push-on connectors 102 are inserted through alignment panel 100 and board 72, after which a soldering connection is made in the same manner as discussed above with respect to the board access portion 92.

Alignment plates 61 and 75 can be formed from an insulating material, and are preferably made of a clear acrylic or polycarbonate plastic sold by General Electric under the Lexan brand.

The transparency of these plates contributes to ease of assembly and service. Fig. 3 shows them to be sized differently from each other. However, they could just as well be identical. Alignment plates 100 and 106 can also be made of this material, although its transparency is not a helpful characteristic for these two plates.

Although a preferred embodiment of the present invention has been described in detail above, it should be readily apparent that various modifications thereto can be made. For example, a test fixture can utilize wiring in combination with the interface means of this invention if required, such as when heavy gauge wires are needed for power wiring. All such changes are to be considered within the scope of the present invention as defined by the following claims.

## Claims

1. A test fixture for checking a printed circuit board comprising:
an array of electrically conductive pins facing in a common direction with a tail at one end and a contact head at another end;
mounting means for securely retaining said array of electrically conductive pins in alignment with test points on a printed circuit board test unit;
means for bringing said array of electrically conductive pins and the test points on said test unit into engagement with each other, respectively;
a contact panel mounting an array of probes adapted to engage a corresponding array of contacts connected to a computerized source of test signals designed for checking said test unit; and
an interface coupled between the probes of said contact panel and the array of electrically conductive pins, said interface comprising:
an interface board having an access portion and a contact panel portion, said access portion including an array of connectors secured to said interface board and aligned, respectively, in positions corresponding to, and being in electrical contact with, the array of electrically conductive pins, said contact panel portion having an array of connectors secured to said interface board and aligned, respectively, in positions corresponding to, and being in electrical contact with, the contact panel probes, and a pattern of conductive lines on said interface board connecting respective ones of said array of connectors on the access portion with respective ones of said array of connectors on the contact panel portion.

2. The printed circuit board test fixture of claim 1, further comprising a first alignment plate having holes aligned with and corresponding to said test points, respectively, accommodating therein the tail end of each pin in the array of electrically conductive pins, and positioned between the interface board and the mounting means.

3. The printed circuit board test fixture of claim 2, wherein each of said electrically conductive pins has a juncture point at which it widens from the tail end, the holes of said first alignment plate being sized to fit snugly around said tail end with the first alignment plate resting on the electrically conductive pins at said juncture point.

4. The printed circuit board test fixture according to anyone of the claims 1 to 3, wherein each of the array of connectors in the access portion of said interface board comprises a female end for receiving therein the tail of an electrically conductive pin, and tapering into an elongated shaft that is accommodated in the holes of the access portion of said interface board.

5. The printed circuit board test fixture of claim 4, further comprising a second alignment plate adjacent said interface board and having holes for accommodating therein the shaft of each of the array of connectors in the access portion of said interface board.

6. The printed circuit board test fixture of claim 5, wherein the female end is wider than the diameter of the holes in the second alignment plate, and the second alignment plate is retained between the interface board and the female end of said array of connectors in the access portion.

7. The printed circuit board test fixture according to anyone of the claims 1 to 6, wherein each of the connectors in the access prtion of said interface board is secured to the interface board.

8. The printed circuit board test fixture of claim 7, wherein each of said conductive lines is connected, respectively, to one of the array of connectors in the access portion of said interface board.

9. The printed circuit board test fixture according to onyone of the claims 1 to 8, wherein said interface further comprises a third alignment plate adjacent said interface board and having holes therein corresponding to the array of connectors in the contact panel portion of the interface board.

10. The printed circuit board test fixture according to anyone of the claims 1 to 9, wherein each of the array of connectors in the contact panel portion of said interface board comprises a female end for receiving therein one of the contact panel probes, and tapering into an alongated shaft that is accommodated in the holes of the contact panel portion of said interface board.

11. The printed circuit board test fixture of claim 10, wherein the female end is wider than the diameter of the holes in the third alignment plate, and the third alignment plate is retained between the interface board and the female end of said array of connectors in the contact panel portion.

12. The printed circuit board test fixture of claim 11, wherein each of the connectors in the contact panel portion of said interface board is secured to the interface board.

13. The printed circuit board test fixture of claim 12, wherein each of said conductive lines is connected, respectively, to one of the array of connectors in the contact panel portion of said interface board.

14. The printed circuit board test fixture according to anyone of the claims 1 to 13, further comprising guide means for inserting the respective tail end of said electrically conductive pin into the holes of said first alignment plate.

15. The printed circuit board test fixture according to anyone of the claims 1 to 14, wherein said conductive lines comprise lines on a printed circuit board.

16. The printed circuit board test fixture according to anyone of the claims 1 to 15, wherein said conductive lines comprise insulated wires on a printed wire board.

17. A method of manufacturing a test fixture for use in computerized testing of printed circuit boards, comprising the steps of:

mounting an array of electrically conductive pins in positions corresponding with test points on a printed circuit board test unit;

aligning the array of pins by placing a first alignment plate so the pins are snugly received within holes in said plate, the holes in said alignment plate being located in positions corresponding with test points on a printed circuit board test unit;

electrically coupling the pins, respectively, to discrete points on an interface board;

providing an interface board and forming a pattern of conductive lines thereon connecting, respectively, said discrete points and an array of points on a contact panel portion of said interface board adapted to receive computerized test signals for testing said printed circuit board test unit;

18. The method of claim 17, wherein the step of coupling the pins to the interface board comprises the steps of mounting connectors in the holes formed in said interface board at said discrete points, and placing said connectors in contact with said pins.

19. The method of claim 17 or 18, further comprising the step of placing a second alignment panal adjacent said interface board to snugly receive said connectors in holes forms therein.

20. An interface board for use in a test fixture which is part of a computerized system for checking printed boards, said interface board comprising:

an access portion and a contact panel portion;

said access portion including an array of discrete electrical contact points corresponding in position to selected test points on a printed circuit board test unit;

said contact panel portion including an array of discrete electrical contact points corresponding in position to pins mounted in the computerized test system and adapted to be coupled to a source of test signals; and

a pattern of conductive lines electrically connecting the respective contact points in the access portion and contact panel portion of the interface board.

# Fig.1

EP 0 299 232 A1

# Fig.1A

# Fig. 2

Fig.3

EP 0 299 232 A1

# Fig.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | FR-A-2 524 649 (THOMSON-CSF)<br>* Figures 1,2; page 1, lines 12-16 *<br>--- | 1,15,17,20 | G 01 R 1/073 |
| A | US-A-4 230 985 (MATRONE et al.)<br>--- | 4,10,18 | |
| X | INSTRUMENTS & CONTROL SYSTEMS, vol. 55, no. 10, October 1982, pages 63-66, Radnor, Pennsylvania, US; G. F. UDALL: "Specifying test fixtures for automated test equipment"<br>* Figure 2 *<br>--- | 4,10,18 | |
| P,X | ELECTRONIC ENGINEERING, vol. 59, no. 729, September 1987, page 16, Woolwich, London, GB; "New ATE jig and fixture developments"<br>----- | 1-20 | |

TECHNICAL FIELDS
SEARCHED (Int. Cl.4)

G 01 R 1/00

The present search report has been drawn up for all claims

| Place of search | Date of completion of the search | Examiner |
|---|---|---|
| THE HAGUE | 02-10-1988 | HOORNAERT W. |

EPO FORM 1503 03.82 (P0401)